(19) Europäisches Patentamt
European Patent Office
Office européen des brevets

(11) Veröffentlichungsnummer: **0 015 403**
**B1**

(12) # EUROPÄISCHE PATENTSCHRIFT

(45) Veröffentlichungstag der Patentschrift: **26.10.83**

(51) Int. Cl.³: **H 01 L 21/263**

(21) Anmeldenummer: **80100648.7**

(22) Anmeldetag: **08.02.80**

(54) **Verfahren zum reaktiven Ionenätzen von Silicium.**

(30) Priorität: **21.02.79 US 13696**

(43) Veröffentlichungstag der Anmeldung:
**17.09.80 Patentblatt 80/19**

(45) Bekanntmachung des Hinweises auf die Patenterteilung:
**26.10.83 Patentblatt 83/43**

(84) Benannte Vertragsstaaten:
**DE FR GB**

(56) Entgegenhaltungen:
**DE - A - 2 046 956**
**DE - A - 2 449 731**
**FR - A - 2 376 904**
**US - A - 4 094 732**

**IBM TECHNICAL DISCLOSURE BULLETIN, Band 16, Nr. 6, November 1973 New York, R. ANDERSON et al. "Etching of SiO using plasma"**
**JOURNAL OF THE ELECTROCHEMICAL SOCIETY, Band 118, Nr. 2, Februar 1971 Princeton P. RAI-CHOUDHURY "Sulfur Hexafluoride as an Etchant for Silicon"**

(73) Patentinhaber: **International Business Machines Corporation**
**Old Orchard Road**
**Armonk, N.Y. 10504 (US)**

(72) Erfinder: **Forget, Lawrence Edmund**
**Robert Road**
**Poughkeepsie New York 12603 (US)**
Erfinder: **Gdula, Robert Anthony**
**Smith Road**
**Pleasant Valley New York 12569 (US)**
Erfinder: **Hollis, Joseph Carter**
**Beach Road**
**Poughquag New York 12570 (US)**

(74) Vertreter: **Oechssler, Dietrich Dr. rer. nat.**
**Schönaicher Strasse 220**
**D-7030 Böblingen (DE)**

**EP 0 015 403 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

# Verfahren zum reaktiven Ionenätzen von silicium

Die Erfindung betrifft ein Verfahren zum Ätzen von Silicium, bei dem die zu ätzenden Siliciumbereiche mit einem Plasma in Berührung gebracht werden, bei dessen Erzeugung von einer Gasmischung ausgegangen wird, welche $SF_6$ und ein Inertgas enthält.

Ein wichtiger Schritt bei der Herstellung von Halbleiterchips und Dünnfilmschaltungen ist das Ätzen der verschiedenen Schichten, wie z.B. Schichten aus polykristallinem Silicium (Polysilicium) und (einkristallinem) Silicium, aus welchen das fertige Halbleiterchip oder die fertige Dünnfilmschaltung besteht. Bei der Herstellung von Dünnfilmschaltungen besteht eine Ätzmethode darin, auf die zu ätzende Oberfläche eine geeignete Ätzmaske aufzubringen und das so maskierte Teil in eine chemische Lösung einzutauchen, welche die zu ätzende Oberfläche angreift, jedoch die Maske intakt läßt. Mit den bis jetzt bekannten naßchemischen Ätzverfahren ist es schwierig gewesen, genau definierte Ränder der geätzten Oberflächen zu erhalten. Die Schwierigkeit kommt daher, daß die verwendeten Chemikalien dazu neigen, die Maske zu unterätzen, d.h. mit anderen Worten, daß die Chemikalie unter die Maske sickert und dann das zu ätzende Material auch in den maskierten Bereichen wegätzt. Eine damit verwandte Schwierigkeit, welche bei verschiedenen Materialien auftritt besteht darin, daß das chemische Ätzmittel nicht nur das zu ätzende Material entfernt, sondern auch noch, nachdem es das zu ätzende Material entfernt hat, das darunterliegende Substratmaterial angreift. Es ist deshalb schwierig, ein naßchemisches Ätzverfahren bei der Herstellung feiner Strukturen mit kleinen Abmessungen einzusetzen. Dabei sollen unter feinen Strukturen solche, verstanden werden, welche Abmessungen in der Größenordnung von 1 $\mu$m haben.

Das Ätzen von Dünnfilm-Schaltkreisen ist auch mit einem Verfahren durchgeführt worden, welches manchmal als Kathodenzerstäubungsätzen bezeichnet wird. Dabei wird im allgemeinen ein Behälter, beispielsweise eine Glasglocke, welche mit einem Inertgas, wie z.B. Argon gefüllt ist, verwendet. In dem Behälter befinden sich eine Anode und eine Kathode, von denen die letztere gegenüber der ersteren beispielsweise mittels eines angelegten Hochfrequenz-Vorspannsignal negativ vorgespannt ist. Die zu ätzende Oberfläche wird mit einer geeigneten Maske, aus einem Material, wie z.B. Fotolack, Siliciumnitrid usw., bedeckt und wird dann auf die Kathode gelegt. Wenn eine negative Vorspannung an die Kathode angelegt wird, wird das inerte Gas im Bereich zwischen der Kathode und der Anode ionisiert und die positiven Ionen werden in Richtung der Kathode beschleunigt. Diejenigen Ionen, welche die zu ätzende Oberfläche treffen, haben den Effekt, daß sie Atome aus der Oberfläche herausschlagen, wodurch das Material allmählich weggeätzt wird. Bei diesem Prozeß wird das Fotolackmaterial, aus welchem die Maske besteht, auch geätzt, und zwar im allgemeinen genauso schnell oder sogar schneller wie das Material, das eigentlich geätzt werden soll. Deshalb sind dicke Maskierungsschichten erforderlich, bei deren Bearbeitung es schwierig ist, festgelegte Abmessungen mit der notwendigen Genauigkeit einzuhalten. Zwar werden mit dem Kathodenzerstäubungsätzen besser definierte Kanten als mit dem naßchemischen Ätzverfahren erzeugt, jedoch ist das Kathodenzerstäubungsätzen, insbesondere beim Ätzen von Tantaloder Nitridoberflächen, welche bei Dünnfilmbauteilen eine große Rolle spielen, sehr langsam.

Bei der Herstellung von Halbleiterchips, wird ein anderes Verfahren, welches manchmal als Plasmaätzen bezeichnet wird, benutzt, bei dem ein Behälter, wie z.B. eine Glasglocke, mit einem Gas, wie z.B. $CF_4$ oder $SF_6$, aus welchem chemisch reaktive Ionen entstehen können, gefüllt ist. Eine Oberfläche, welche geätzt werden soll, wird mit einer Maske bedeckt und dann in den Behälter zusammen mit dem reaktiven Gas gebracht. Um die Oberfläche zu ätzen, wird eine Hockfrequenz erzeugende Spule, welche den Behälter umgibt, aktiviert, um das $CF_4$ oder das $SF_6$ anzuregen, wodurch diese Moleküle dissoziieren und verschiedene positive und negative Ionen bilden. Die erzeugten Ionen reagieren dann offenbar chemisch mit der zu ätzenden Oberfläche, wobei unterschiedliche Gase als Reaktionsprodukt entstehen. Wie oben bei den naßchemischen Ätzverfahren beschrieben worden ist, erfolgt auch beim Plasmaätzen ein Unterätzen der Maskenbereiche, so daß es auch bei diesem Ätztyp schwierig ist, gut definierte Kanten zu erzielen.

Das reaktive Ionenätzen bzw. Plasmaionenätzen ist wohlbekannt. Die im folgenden angesprochenen Patente sollen den vorhandenen Stand der Technik aufzeigen.

Im US-Patent 3 079 502 mit dem Titel "Nicht bevorzugtes Ätzen von Silicium in einer Gasatmosphäre" ist ein Verfahren offenbart, bei dem eine Siliciumoberfläche mit einer Gasmischung, welche aus Schwefelhexafluorid ($SF_6$) hoher Reinheit und einem Trägergas wie z.B. Wasserstoff besteht, bei Temperaturen zwischen 950 und 1250°C geätzt oder poliert wird. Das $SF_6$ sollte dabei eine niedrige Stickstoffkonzentration, welche bevorzugt bei weniger als 200 Gewichts-ppm liegt, haben.

Beim Gegenstand des US-Patents 3 806 365 handelt es sich um ein Verfahren zum Entfernen von Fotolackmaterial und den in ihm enthaltenen anorganischen Verunreinigungen nach den Verfahrensschritten des Entwickelns und des Ätzens von vom Fotolackmaterial nicht abgedeckten Bereichen einer Oxydschicht auf einer Halbleiterscheibe. Bei diesem Verfahren wird das Fotolackmaterial bei einem niedrigen Druck (einige µbar) einem hochfrequenzerzeugten kalten Plasma (200—300°C) ausgesetzt, wobei das Plasma aus einer homogenen gasförmigen Mischung aus Sauerstoff und organischen Halogenverbindungen besteht. Bei den organischen Halogenverbindungen handelt es sich bevorzugt um eine binäre oder ternäre Mischung, wobei jeder Bestandteil bevorzugt nicht mehr als 2 Kohlenstoffatome pro Molekül enthält und voll halogen substituiert ist. Bevorzugte Substituenten sind Fluor oder Fluor-Brom-Kombinationen.

Im US-Patent 3 880 684 ist ein Verfahren zum kontinuierlichen Ätzen von Schichten aus mindestens zwei Typen von Siliciummaterialien, wie z.B. Siliciumdioxyd ($SiO_2$) und Siliciumnitrid ($Si_3N_4$), oder polykristallinem Silicium, welche auf einem Siliciumsubstrat aufgebracht sind, beschrieben. Zum Ätzen wird ein Freon (organische Halogenverbindung)-Gasplasma in der Weise verwendet, daß die mindestens zwei Typen von Siliciummaterialien kontinuierlich geätzt werden, wobei sich wie beim konventionellen naßchemischen Ätzen abgeschrägte Seitenwände bilden und Unterätzung auftritt.

Im US-Patent 3 923 585 ist ein Verfahren zum Ätzen von Edelmetallen mittels eines Gasplasmas beschrieben. Das Verfahren wird insbesondere zum Entfernen von ausgewählten Bereichen dünner Filme von elektrisch leitfähigen Edelmetallen verwendet und wird in der Weise durchgeführt, daß man die freiligenden Bereich des Edelmetalls einem Plasma, welches Fluor und Chlor enthalten muß und Sauerstoff enthalten kann, aussetzt.

Im US-Patent 3 971 684 ist ein Verfahren zum Ätzen von Dünnfilmschaltungen oder Halbleiterchips offenbart, welches in der Lage ist, außerordentlich gut definierte Kanten in den zu ätzenden Materialien zu erzeugen. Gleichzeitig sind bei diesem Verfahren die Ätzgeschwindigkeiten hoch. Gemäß dem Verfahren wird ein Gas oder eine Gasmischung aus dem bzw. aus der bei der Dissoziation chemisch reaktive Ionen entstehen, in einen Behälter gebracht, in dem sich eine Kathode und eine Anode befinden. Die zu ätzende Oberfläche wird mit einer geeigneten Maske teilweise abgedeckt und dann auf eine der Elektroden, beispielsweise die Kathode gelegt, welche gegenüber der anderen Elektrode, beispielsweise durch Anlegen eines Hockfrequenz-Vorspannsignals (RF biasing signal) negativ vorgespannt ist. Dabei wird im Raum zwischen der Kathode und der Anode ein elektrisches Feld aufgebaut, welches dazu dient, das reaktive Gas zu dissoziieren. Chemisch reaktive Gasionen werden von der Kathode augezogen und prallen dabei auf die zu ätzende Probe auf. Offenbar wird die Oberfläche sowohl durch chemische Wechselwirkung mit den chemisch aktiven Ionen als auch aufgrund der kinetischen Energie der auf der Oberfläche aufprallenden Ionen geätzt. Aufgrund des elektrischen Feldes, welches die Ionen in Richtung der Kathode treibt, treffen die Ionen auf der zu ätzenden Oberfläche vorwiegend in einer Richtung auf, welche senkrecht zu dieser Oberfläche ist, so daß das Verfahren gut definierte, vertikal geätzte Seitenwände produziert. Als chemisch reaktive Gase können $SF_6$ oder $CCl_2F_2$ angewandt werden, jedoch wird $CF_4$ bevorzugt.

In dem US-Patent 3 994 793 ist ein Verfahren zum reaktiven Ionenätzen von Aluminium beschrieben, bei dem eine maskierte Aluminiumschicht, welche auf einem Substrat aufliegt, einem Hochfrequenzplasma, welches dadurch erzeugt wird, daß eine Hochfrequenzspannung zwischen mindestens zwei voneinander getrennte Elektroden gelegt wird, in einer Gasatmosphäre ausgesetzt wird, welche aus einem inerten Gas und einem Gas aus der Gruppe $CCl_4$, $Cl_2$, $Br_2$ und HCl zusammengesetzt ist.

Im US-Patent 4 026 742 ist ein Verfahren zum Ätzen von einheitlichen Schichten von elektrisch leitfähigen Metallen offenbart. Das Verfahren wird bei der Herstellung von Bauelementen mit Mikroschaltungen verwendet, und zwar zum selektiven Ätzen von Schichten aus einem elektrisch leitfähigen Metall, welche auf der Oberfläche der Mikroschaltungen aufgebracht sind. Beim Ätzen werden die nicht von einer Maske abgedeckten Metallbereiche in einem Plasma einem reaktiven halogenierten Gas ausgesetzt, wobei das Metall in ein Metallhalogenid umgewandelt wird. Nach dem Entfernen des Metallhalogenids bleibt auf dem Bauteil ein Muster aus elektrisch leitfähigem Metall zurück. Das Plasma kann in einer Reaktionskammer mittels eines hochfrequenten elektromagnetischen Feldes erzeugt werden. Das Verfahren ist nützlich bei der Herstellung eines gewünschten Metallmusters, welches beispielsweise die Funktion der Verdrahtung in der Mikroschaltung übernimmt. Das Verfahren ist insbesondere vorteilhaft beim Ätzen von aus Wolfram oder Molybdän bestehenden Mustern. Zu den bevorzugten halogenierten Materialien gehören perhalogenierte organische Verbindungen, wie z.B. Trichlorfluormethan, Dichlordifluormethan oder andere flüchtige organische Verbindungen, welche Halogenatome mit einer Atomnummer zwischen 9 und 35 enthalten. Als besonders günstig haben sich Chlor- und Fluoratome erwiesen, jedoch können auch bromierte Verbindungen, wie z.B. $CHBr_3$, $CH_2Br_2$ oder $CH_3Br$ verwendet werden.

Im US-Patent 4 052 251 ist ein Verfahren zum Ätzen eines Sackloches, mit einem gleichschenklig trapezförmigen Querschnitt in ein Saphirsubstrat beschrieben. Als Ätzgas wird bei diesem Verfahren Schwefelhexafluorid verwendet und als Ätzmaskenmaterial dient Siliciumnitrid, welches auf einer Siliciumdioxydschicht, welche ihrerseits das Saphirsubstrat bedeckt, aufgebracht ist.

Im US-Patent 4 069 096 ist ein Verfahren zum Ätzen von Silicium offenbart. Dabei wird das Silicium mit einem Gasplasma in Berührung gebracht, welches aus einer Gasmischung, welche $CCl_4$, ein Inertgas und $Cl_2$ oder HCl enthält, hervorgegangen ist.

Im US-Patent 4 094 732 ist ein Verfahren zum Ätzen von Silicium offenbart, bei dem das Silicium einem Gasplasma, welches aus einem Gasgemisch aus $CCl_4$, $Cl_2$ und einem Inertgas hervorgegangen ist, ausgesetzt wird. Als Inertgas wird Stickstoff oder Argon verwendet.

Es ist die Aufgabe der Erfindung, ein neues Verfahren anzugeben um Silicium rasch und in Gegenwart von in der Halbleitertechnik gängigen Materialien bevorzugt, d.h. wesentlich schneller als diese zu ätzen.

Diese Aufgabe wird mit einem Verfahren der eingangs genannten Art mit dem Merkmal des kennzeichnenden Teils des Anspruchs 1 gelöst.

Bei der Durchführung des erfindungsgemäßen Verfahrens wird das Silicium mittels reaktiven Ionenätzens entfernt. Die Technik des reaktiven Ionenätzens ist bei der Herstellung von integrierten Schaltungen insbesondere bei der Herstellung von Leitungen mit kleiner Linienbreite unter Einhaltung enger Toleranzen günstig. Beispielsweise muß zum Herstellen von Feldeffekttransistoren, an deren Aufbau zwei Polysiliciumschichten beteiligt sind, Polysilicium selektiv in der Gegenwart von $SiO_2$ geätzt werden. Es muß dabei eine 400 nm dicke Polysiliciumschicht geätzt werden, welche sich auf dem 25 bis 50 nm dicken Gateoxid befindet. Damit das Gateoxid beim Siliciumätzen praktisch nicht angegriffen wird, ist es notwendig, daß das Verhältnis der Geschwindigkeiten, mit denen Si und $SiO_2$ geätzt werden ($Si/SiO_2$-Ätzgeschwindigkeitenverhältnis) mindestens 25:1 ist. Es ist versucht worden, dieses Atzproblem mit dem in dem US-Patent Nr. 3 971 684 beschriebenen Verfahren zu lösen. Bei dem dort beschriebenen reaktiven Ionenätzverfahren, bei welchem von einer Gasmischung ausgegangen wird, welche $SF_6$ und Helium enthält, sind zwei Ätzmechanismen beteiligt. Der eine Mechanismus ist rein chemisch und läuft wahrscheinlich nach der Gleichung ab

$$Si + 4F^{\circ} \longrightarrow SiF_4 \text{ (gas)}.$$

Das Silicium wird dabei isotrop geätzt, woraus ein Ätzprofil sich ergibt, wie es in der Fig. 1A dargestellt ist, und die $Si/SiO_2$-Ätzgeschwindigkeitenverhältnisse sind hoch. Beim anderen Mechanismus handelt es sich wahrscheinlich um einen ionenunterstützen Mechanismus, bei dem $SF^+_y$-Ionen (y kann Werte zwischen 2 und 5 annehmen) mit Silicium unter Bildung eines gasförmigen Produkts reagieren. Bei diesem zweiten Mechanismus ist das Ätzen gerichtet, wodurch beim Ätzen vertikale Seitenwände, wie sie die Fig. 1B wiedergibt, entstehen. Mit dem in der genannten US-Patentschrift beschriebenen Plasma können die Parameter so eingestellt werden, daß der Ätzvorgang völlig gerichtet abläuft und dann die Ätzmaske überhaupt nicht unterätzt wird, jedoch muß dieser Vorteil mit einer Erniedrigung des $Si/SiO_2$-Ätzgeschwindigkeitenverhältnisses erkauft werden. Das höchste Ätzgeschwindigkeitenverhältnis, das erreicht werden kann, wenn die Seitenwände vollständig vertikal sind, d.h. die Unterätzung der Ätzmaske gleich null ist, liegt bei 12:1. Ein solches Ätzgeschwindigkeitenerhältnis ist nicht hoch genug, wenn das Gateoxid nur 25 nm dick ist. Wird jedoch erfindungsgemäß von einer Gasmischung ausgegangen, welche außer $SF_6$ und dem Inertgas noch $Cl_2$ enthält, ist der Bereich, in welchem die Ätzparameter variiert werden können, ohne daß das gerichtete Ätzen in ein ungerichtes Ätzen übergeht, größer, als wenn die Ätzgasmischung kein Chlor enthält. Es ist daher möglich, beim reaktiven Ionenätzen mit niedrigeren Leistungspegeln zu arbeiten, wodurch das $Si/SiO_2$-Ätzgeschwindigkeitenverhältnis sich erhöht, und trotzdem beim Ätzen vertikale oder nahezu vertikale Seitenwände zu erhalten Es ist bei der Durchführung des erfindungsgemäßen Verfahrens möglich, ein $Si/SiO_2$-Ätzgeschwindigkeitenverhältnis von größer 40:1 einzustellen und trotzdem beim Ätzen vertikale Seitenwände, was gleichbedeutend ist mit einer Unterätzung der Ätzmaske, welche gleich null ist, zu erzeugen. Mit der genannten Ausgestaltung des erfindungsgemäßen Verfahrens ist es also nicht nur möglich, sehr selektiv in Gegenwart von in der Halbleitertechnik gängigen Materialien, sondern auch streng gerichtet, zu ätzen.

Mit dem erfindungsgemäßen Verfahren läßt sich Silicium nicht nur in Gegenwart von $SiO_2$ sondern auch in Genenwart $Si_3N_4$ besonders vorteilhaft selektiv ätzen.

In vorteilhafter Weise wird die Selektivität bzw. die Gerichtetheit des Ätzens außer über die Zusammensetzung der Gasmischung und über die Eingangsleistung zusätzlich über den Gasdruck in der Reaktionskammer gesteuert. Darauf wird in der Beschreibung anhand der Fign. 3 und 4 noch eingegangen.

Weitere vorteilhafte Ausgestaltungen des erfindungsgemäßen Verfahrens ergeben sich aus den Unteransprüchen.

Die Erfindung wird anhand von durch Zeichnungen erläuterten Ausführungsbeispielen beschrieben.

Es zeigen:

Fig. 1A im Querschnitt einen mittels eines bekannten isotropen Ätzverfahrens geätzten Leiters aus polykristallinem Silicium (Polysilicium),

Fig. 1B im Querschnitt ein mittels des erfindungsgemäßen Verfahrens geätzter Leiter aus Polysilicium,

Fig. 2 in drei Diagrammen, in welchen von

unten nach oben die Geschwindigkeit mit der $SiO_2$, die Geschwindigkeit mit der Si (Ätzgeschwindigkeit von $SiO_2$ bzw. von Si) geätzt werden und das Verhältnis der Geschwindigkeiten, mit denen Si und $SiO_2$ geätzt werden, gegen den prozentualen Chlorgehalt in der Ätzgasmischung aufgetragen sind,

Fign. 3+4 Diagramme, in welchen Verhältnisse der Geschwindigkeiten, mit welchen Si und $SiO_2$ mittels des reaktiven Ionenätzens für drei unterschiedlich zusammengesetzte Ätzgasmischungen gegen die Eingangsleistung bzw. gegen den in der Kammer herrschenden Reaktionsdruck aufgetragen sind.

Fign. 5A+5B im Querschnitt zwei Stadien der Herstellung eines Feldeffekttransistors gemäß der Erfindung und,

Fign. 6A bis 6D vier Stadien der Herstellung gemäß der vorliegenden Erfindung einer eingelegten Oxidisolation in einem Siliciumchip.

Der in der Fig. 1A im Querschnitt gezeigte Polysilicium-Leiter wurde under Verwendung eines isotropen Ätzverfahrens, wie z.B. eines Naßchemischen Ätzverfahrens oder des Plasmaätzens, erzeugt. Man erkennt in der Figur das starke Unterätzen der Ätzmaske. Dieses Unterätzen hat zur Folge, daß sich die Abmessungen der Maske und des geätzten Leiters stark unterscheiden. Dieser Unterschied wird Ätzüberhang (etch bias) genannt.

Der in der Fig. 1B im Querschnitt gezeigte selektiv geätzte Leiter aus Polysilicium wurde mittels eines Verfahrens erzeugt, bei welchem—wie bei dem erfindungsgemäßen Verfahren—gerichtet geätzt wurde. Man sieht, daß kein Ätzüberhand vorhanden ist, d.h., daß sich der geätzte Leiter und die Maske in ihren Abmessungen praktisch nicht unterscheiden.

Die Fig. 2 zeigt experimentelle Daten, welche beim reaktiven Ionenätzen unter Verwendung eines Ätzgases erzielt wurden, welches 90 % Helium und 10 % $SF_6$+$Cl_2$ enthielt. (Alle in dieser Anmeldung genannten Anteile sindsofern nichts anders vermerkt ist—Volumenanteile).

Abgesehen von dem Verhältnis von $SF_6$ zu $Cl_2$ wurden bei den Experimenten alle Bedingugen konstant gehalten. Die wesentlichen Fakten, welche dem Diagramm zu entnehmen sind, sind

1. daß die Ätzgeschwindigkeit, mit der Silicium geätzt wird, durch den Ersatz des $SF_6$ durch $Cl_2$ zunächst erhöht wird und sich, wenn weiteres $SF_6$ durch $Cl_2$ ersetzt wird, erniedrigt, so daß, wenn das gesamte $SF_6$ durch $Cl_2$ ersetzt ist, die Ätzgeschwindigkeit mit der Silicium geätzt wird, wesentlich niedriger ist als bei Verwendung eines nur Helium und $SF_6$ enthaltenden Ätzgases, daß

2. die Geschwindigkeit, mit der $SiO_2$ geätzt wird, sich zunächst stark erniedrigt, wenn damit angefangen wird, $SF_6$ durch $Cl_2$ zu ersetzen und dann bei weiterem Ersatz des $SF_6$ durch $Cl_2$ praktisch konstant bleibt und daß

3. sich aus diesen Beeinflussungen der Geschwindigkeiten mit der Si und $SiO_2$ geätzt werden, eine beachtliche Verbesserung des Si/$SiO_2$-Ätzgeschwindigkeitenverhältnisses ergibt, wenn ein Teil des $SF_6$ durch $Cl_2$ ersetzt wird. Die Bedingungen bei den Experimenten sind so gewählt worden, daß das Ätzen gerichtet ist, so daß im wesentlichen vertikale Ätzprofile—wie sie die Fig. 1B wiedergibt—erhalten werden.

In der Fig. 3 sind die Ergebnisse eines reaktiven Ionenätz-Experimentes gezeigt, bei welchem drei verschiedene Ätzgase, und zwar ein 10 % $SF_6$ und 90 % He, ein 12 % $Cl_2$ und 88 % Ar enthaltendes Ätzgas und eine Gasmischung gemäß der Erfindung, welche 5 % $SF_6$, 5 % $Cl_2$ und 90 % He enthält, miteinander verglichen werden. Das Diagramm zeigt, wie die Si/$SiO_2$-Ätzgeschwindigkeitenverhältnisse sich in Abhängigkeit von der Eingangsleistung ändern. Man ersieht aus dem Diagramm eindeutig, daß bei Verwendung des gemäß Erfindung zusammengesetzten Ätzgases das Si/$SiO_2$-Ätzgeschwindigkeitenverhältnis besser liegt als bei Verwendung der genannten bekannten Ätzgasmischungen. Dies ist ein klarer Fall von Synergismus. Das in der Fig. 4 gezeigte Diagramm zeigt den Einfluß des Gasdrucks in der Reaktionskammer auf das Si/$SiO_2$-Ätzgeschwindigkeitenverhältnis bei Verwendung der drei genannten Gasmischungen. Bei allen untersuchten Drücken war das Si/$SiO_2$ bei Verwendung des gemäß der Erfindung zusammengesetzten Ätzgases am besten. Dies zeigt die Fig. 4 deutlich.

Die Fig. 5A zeigt im Querschnitt einen durch eingelegte $SiO_2$-Bereiche definierten Halbleiterbereich, in welchem ein FET erzeugt werden soll. Die Fig. 5A zeigt das Herstellungsstadium, nachdem die Gate-Oxidschicht, eine Polysiliciumschicht, aus welcher das Gate erzeugt werden soll, und die das Gate definierende Maske aufgebracht worden sind.

Die Fig. 5B zeigt im Querschnitt die in der 5A gezeigte Struktur, nachdem das Gate aus der Polysiliciumschicht unter Verwendung der Maske mittels reaktiven Ionenätzens gemäß der Erfindung erzeugt worden ist. Man sieht, daß die Maske nicht unterätzt ist. Dies ist wichtig, weil in dem nachfolgenden Schritt der Ionenimplantation, bei welchem die Source- und Drain-Gebiete erzeugt werden, das beim reaktiven Ionenätzen hergestellte Gate als selbstausgerichtete (self aligned) Maske dient. Ein Unterätzen der Maske während des reaktiven Ionenätzens würde eine Fehljustierung der Source- und Drain-Gebiete bezüglich des Gates verursachen.

Die Fig. 6A zeigt im Querschnitt einen Oberflächenbereich eines Siliciumchips, auf welchem eine sehr hoch integrierte Schaltung erzeugt werden soll. In dem dargestellten Bereich soll eine eingelegte Oxidisolation aufgewachsen werden. Die aus $Si_3N_4$ und $SiO_2$ bestehende Beschichtung soll dabei als

Oxidationsmaske dienen. Die Fig. 6B zeigt die in der Fig. 6A gezeigte Struktur, nachdem in die $Si_3N_4$- $SiO_2$-Beschichtung mittels Plasmaätzens ein der gewünschten eingelegten Isolation entsprechendes Muster geätzt und die Fotolackmaske abgelöst worden ist. Die Fig. 6C zeigt die in den Fign. 6A und 6B gezeigte Struktur, nachdem mittels reaktiven Ionenätzens gemäß der Erfindung Gräben in das Silicium mit <100>-orientierter Oberfläche unter Verwendung der $Si_3N_4$-$SiO_2$-Maske erzeugt worden sind. Man stellt fest, daß die Atzmaske dabei nicht unterätzt worden ist.

Die Fig. 6D zeigt die in der Fig. 6C gezeigte Struktur, nachdem die Oxydation stattgefunden hat. Da bei der Ätzung (siehe Fig. 6C) keine Unterätzung stattgefunden hat, läßt sich die laterale Erstreckung der Oxidisolation genau kontrollieren und, da infolgedessen die bei der Schaltungsauslegung einzuhaltenden Toleranzen sehr klein sind, kann auch die Packung der Bauelemente auf dem Chip optimal dicht gemacht werden.

Wie die gezeigten, vorteilhaften Ausführungsformen zeigen, lassen sich mit dem erfindungsgemäßen Verfahren Dünnfilmschaltkreise bzw. Halbleiterchips so ätzen, daß sehr gut definierte Ätzkanten entstehen und gleichzeitig die Ätzgeschwindigkeiten hoch sind. Bei der Durchführung des erfindungsgemäßen Verfahrens wird ein Gasgemisch, welches $Cl_2$ und $SF_6$ in einem Inertgas, wie z.B. Helium, enthält in einem Container gebracht, in welchem sich eine Kathode und eine Anode befinden. Der Körper, dessen eine Oberfläche mit einer geeigneten Maske bedeckt ist und geätzt werden soll, ist auf einer der Elektroden, beispielsweise der Kathode, befestigt, welche gegenüber der anderen Elektrode, beispielsweise mittels eines Hochfrequenz-Vorspannsignals, negativ vorgespannt ist. Auf diese Weise wird ein elektrisches Feld in dem Bereich zwischen der Kathode und der Anode erzeugt, welches dazu dient, das reaktive Gas zu dissoziieren, wobei sich ein Plasma bildet. Chemisch reaktive Gaspartikel werden zu der Kathode hingezogen und prallen dabei auf der zu ätzenden Probe auf. Offenbar wird die Oberfläche sowohl durch die chemische Wechselwirkung mit verschiedenartigen aktiven Partikeln als auch durch die kinetische Energie der positiven Ionen, welche auf der Oberfläche aufprallen, geätzt. Aufgrund des elektrischen Feldes, welches die Ionen zu der Kathode hinzieht, treffen die auf der zu ätzenden Oberfläche aufprallenden Ionen überwiegend in einer Richtung auf, welche senkrecht zu dieser Oberfläche ist, so daß das Verfahren gut definierte vertikal geätzte Seitenwände erzeugt. Darüber hinaus erlaubt es die aus $Cl_2$, $SF_6$ und einem Inertgas bestehende Gasmischung Polysilicium in Gegenwart von Siliciumdioxyd oder Siliciumnitrid selektiv, d.h. mit einem hohen Ätzgeschwindigkeitenverhältnis zu ätzen.

Die Herstellung von sehr hoch integrierten Bauteilen (very large scale integrated (VLSI) devices) unter Anwendung der Siliciumtechnologie erfordert das Ätzen von Leiterzügen und Mustern, deren Abmessungen im Submikronbereich liegen, aus Silicium heraus. Um dies fertigzubringen, muß das Ätzverfahren zwei Eigenschafter aufweisen. Erstens muß die Ätzung gerichtet erfolgen, d.h., daß das Ätzen entweder bevorzugt senkrecht zur zu ätzenden Oberfläche (anisotrop) oder ausschließlich senkrecht zur zu ätzenden Oberfläche erfolgt. Es kann nämlich leicht gezeigt werden, daß beim isotropen Ätzen (ein solches Ätzen findet bevorzugt beim naßchemischen Ätzen statt) die minimale Linienbreite, welche geätzt werden kann, etwa doppelt so groß ist wie die Ätztiefe. Zum zweiten muß das Ätzverfahren selektiv sein, was bedeutet, daß Silicium oder Polysilicium geätzt werden kann, ohne daß die Maske erodiert wird und daß es möglich ist, das Ätzen nach dem Durchätzen des Siliciums zu stoppen, ohne daß eine darunter befindliche dünne $SiO_2$-Isolierschicht beachtlich angegriffen wird. Hat das Ätzverfahren diese beiden Eigenschaften, so kann der Ätzüberhang praktisch bei Null gehalten werden, ohne daß die vertikale Struktur gestört wird.

Beim konventionellen Plasmaätzen, bei welchem als Ätzgas $CF_4$ oder ein Gemisch aus $CF_4$ und Sauerstoff verwendet wird, ist zwar die Selektivität gegeben, aber das Ätzen erfolgt isotrop, so daß die Maske unterätzt wird (siehe Fig. 1A). Das reaktive Ionenätzen unter Verwendung von chlorierten Ätzgasen erfolgt zwar gerichtet, hat aber keine gute Selektivität (typisches Ätzgeschwindigkeitenverhältnis 5:1—6:1) und Polysilicium wird uneinheitlichgeätzt. Wie oben schon erläutert wurde, ist das reaktive Ionenätzen von Silicium unter Verwendung von $SF_6$ bekannt, wobei entweder eine hohe Selektivität bei gleichzeitigem isotropen Ätzen oder eine Gerichtetheit der Ätzung bei niedriger Selektivität gegeben ist. Es ist nicht möglich gewesen, eine Gereichtetheit ufd eine hohe Selektivität des Ätzens gleichzeitig zu erreichen.

Die vorliegende Erfindung macht Gebrauch von dem unerwarteten Effekt, daß beim teilweisen Ersatz von $SF_6$ in verdünnten Mischungen von $SF_6$ mit einem Inertgas wie z.B. Helium, durch Chlor eine wesentlich größere Selektivität beim reaktiven Ionenätzen von Silicium erreicht wird als dies möglich ist, wenn beim reaktiven Ionenätzen entweder $Cl_2$ oder $SF_6$ allein vorhanden sind. Dabei bleibt die notwendige Gerichtetheit des Ätzens und die Leichtigkeit mit der Polysilicium geätzt wird, erhalten (siehe Fign. 2, 3 und 4). Dies ist ein klarer Fall von Synergismus, bei dem die Kombination von $Cl_2$ und $SF_6$ unerwarteterweise bessere Ergebnisse liefert, als wenn $Cl_2$ oder $SF_6$ allein verwendet werden.

Die Erfindung ist insbesondere bei der Herstellung von sehr hoch integrierten Siliciumbauelementen nützlich. Insbesondere trifft dies

zu für Bauelemente, welche Feldeffekt-transistoren enthalten, und bei denen die Leiterzüge der ersten und zweiten Ebene aus Polysilicium bestehen. Zum Herstellen der Polysiliciumleiterzüge der ersten Ebene im aktiven Bereich des Bauteils muß ein sehr gut leitfähiger, ungefähr 400 nm dicker Polysiliciumfilm geätzt werden. Under diesem Polysilicium befindet sich das Gateoxid des Bauteils, welches aus einer 20—50 nm dicken thermisch gewachsenen $SiO_2$-Schicht besteht. In das Polysilicium müssen Muster geätzt werden, von denen manche nur eine Linienbreite haben, welche zwischen 1 und 3 $\mu$m liegt, wobei das darunterliegende Gateoxid nicht wesentlich angegriffen werden darf. Dabei muß ein Überschreiten der an sich notwendigen Ätzzeit um 20 % toleriert werden, damit sichergestellt ist, daß das Polysilicium auf allen Siliciumplättchen ganz durchgeätzt ist. Dabei muß ein Ätzüberhang, welcher einen Wert von Null hat, sichergestellt sein.

Die Bedingungen, unter denen geätzt wird, sind die folgenden:

Ätzvorrichtung mit einer Dioden-Konfiguration (wie sie auch in dem US-Patent 3 971 684 verwendet wird).

Die Siliciumplättchen werden auf die beaufschlagte Elektrode (driven electrode) gelegt, welche wassergekühlt ist.

Die Oberfläche der Elektrode, auf welcher die Siliciumplättchen liegen, ist bevorzugt mit Qarzglas bedeckt, kann aber auch mit Aluminium oder Silicium bedeckt sein.

Die Anregungsfrequenz kann zwischen 10 kHz und 10 GHz liegen und liegt bevorzugt bei 40,68 MHz.

Das Ätzgas enthält 90 % Helium und enthält zwischen 1 und 9 % $SF_6$, wobei der jeweils zu 100 % fehlende Rest aus $Cl_2$ besteht. Bevorzugt enthält dea Ätzgas 5 % $SF_6$ und 5 % $Cl_2$. Das Helium kann durch Argon ersetzt werden.

Die Flußmenge des Ätzgases kann unter Zugrundelegung von Standardbedingungen zwischen 5 und 100 $cm^3$ pro Minute liegen und liegt bevorzugt bei 25 $cm^3$ pro Minute.

Der Gasdruck in der Kammer kann zwischen 6,67 und 266,64 $\mu$m bar liegen und liegt bevorzugt bei 133,32 $\mu$m bar.

Die Eingangsleistung kann zwischen 0,1 und 0,5 Watt/$cm^2$ liegen und liegt bevorzugt bei 0,25 Watt/$cm^2$.

Das Maskenmaterial besteht bevorzugt aus $SiO_2$, kann aber auch aus Fotolack, $Si_3N_4$ oder Aluminium bestehen.

Unter diesen Bedingungen wird Polysilicium mit einer Ätzgeschwindigkeit von ungefähr 150 nm/Minute geätzt, während das $SiO_2$ mit einer Ätzgeschwindigkeit von 5 nm/Minute geätzt wird, was ein Si/$SiO_2$-Ätzgeschwindigkeitenverhältnis von ungefähr 30:1 ergibt. Unter diesen Bedingungen ist das Ätzen gerichtet, wodurch ein Ätzüberhang mit einem Wert von Null erhalten wird. Beim Ätzen der zweiten Lage Polysilicium sind die Probleme dieselben und es kann ihnen begegnet werden, indem unter denselben Bedingungen wie oben angegeben, gearbeitet wird.

Eine andere Anwendung des erfindungsgemäßen Verfahrens ist das Ätzen von Silicium bei der Herstellung von eingelegten Oxidisolationsbereichen. Dabei wird ein Siliciumkörper mit <100>-orientierter Oberfläche mit Oxid- und Nitrid-Schichten maskiert und muß ungefähr 500 nm tief geätzt werden, wobei die Seitenwände der Vertiefung vertikal und der Ätzüberhang Null sein muß (siehe Fig. 6). Die Selektivität des Ätzens ist dabei auch wichtig. Es müssen nämlich 500 nm Silicium geätzt werden, ohne daß die obere, aus Nitrid bestehende Schicht der Maske gedünnt wird, weil sie bei dem später erfolgenden Aufwachsen der eingelegten Oxidisolation als Oxidationsmaske dient. Dabei haben wir gefunden, daß mehr $Cl_2$ und weniger $SF_6$ in der Gasmischung enthalten sein sollten. Die anderen Bedingungen sind dieselben wie oben angegeben. Es wird bevorzugt ein Gas verwendet, welches 2,5 % $SF_6$, 7,5 % $Cl_2$ und 90 % He enthält. Under diesen Bedingungen wird <100>-orientiertes Silicium mit einer Geschwindigkeit von 80 nm/Minute geätzt. während $Si_3N_4$ nur mit einer Geschwindigkeit von von 3,3 nm/Minute geätzt wird, woraus ein Si/$Si_3N_4$-Ätzgeschwindigkeitenverhältnis von 24:1 folgt. Das Ätzen ist gerichtet und der Ätzüberhang hat einen Wert von Null.

**Patentansprüche**

1. Verfahren zum reaktiven Ionenätzen zon Silicium, bei dem die zu ätzenden Siliciumbereiche mit einem Plasma in Berührung gebracht werden, bei dessen Erzeugung von einer Gasmischung ausgegangen wird, welche $SF_6$ und ein Inertgas enthält, dadurch gekennzeichnet, daß der Gasmischung zusätzlich $Cl_2$ zugemischt wird.

2. Verfahren nach Anspruch 1, dadurch gekennzeichnet, daß die Gasmischung so zusammengesetzt wird, daß der Anteil von $SF_6$ und $Cl_2$ ungefähr 10 Volum-% beträgt und der Rest aus dem Inertgas besteht.

3. Verfahren nach einem der Ansprüche 1 oder 2, dadurch gekennzeichnet, daß der $SF_6$-Anteil in der Gasmischung auf einen Wert zwischen 1 und 9 Volum-% eingestellt wird.

4. Verfahren nach einem der Ansprüche 1 bis 3, dadurch gekennzeichnet, daß als Inertgas Helium oder Argon verwendet wird.

5. Verfahren nach einem der Ansprüche 1 bis 4, dadurch gekennzeichnet, daß polykristallines Silicium geätzt wird.

6. Verfahren nach einem der Ansprüche 1 bis 5, dadurch gekennzeichnet, daß das Silicium in Gegenwart von $SiO_2$ oder $Si_3N_4$ geätzt wird.

7. Verfahren nach Anspruch 6, dadurch

gekennzeichnet, daß der $SF_6$-Anteil in der Gasmischung beim Ätzen in Gegenwart von $SiO_2$ auf ungefähr 5 Volum-% und beim Ätzen in Gegenwart von $Si_3N_4$ auf ungefähr 2,5 Volum-% eingestellt wird.

8. Verfahren nach einem der Ansprüche 1 bis 7, dadurch gekennzeichnet, daß das Ätzgeschwindigkeitenverhältnis außer über die Zusammensetzung der Gasmischung zusätzlich über den Gasdruck in der Reaktionskammer und über die Eingangsleistung (Watt/cm²) gesteuert wird.

9. Verwendung der Verfahren nach einem der Ansprüche 1 bis 8, bei der Herstellung sehr hoch integrierter Schaltungen.

**Revendications**

1. Procédé de décapage de silicium par ions réactifs où les régions de silicium à décaper sont mises en contact avec un plasma généré à partir d'un mélange gazeux contenant $SF_6$ et un gaz inerte, caractérisé en ce qu'on ajoute audit mélange gazeux du $Cl_2$.

2. Procédé selon la revendication 1 caractérisé en ce que ledit mélange gazeux est composé de telle sorte que $SF_6$ et $Cl_2$ représentent environ 10% de son volume total, les autres 90% étant ledit gas inerte.

3. Procédé selon l'une quelconque des revendications 1 ou 2 caractérisé en ce que la proportion de $SF_6$ dont ledit mélange gazeux représente entre 1 et 9% du volume.

4. Procédé selon l'une quelconque des revendications 1 à 3, caractérisé en ce que ledit gaz inerte est de l'hélium ou de l'argon.

5. Procédé selon l'une des revendications 1 à 4, caractérisé en ce que le silicium décapé est polycristallin.

6. Procédé selon l'une quelconque des revendications 1 à 5, caractérisé en ce que le silicium est décapé en présence de $SiO_2$ ou de $Si_3N_4$.

7. Procédé selon la revendication 6, caractérisé en ce que la proportion de $SF_6$ dans ledit mélange gazeux représente environ 5% du volume total quand le décapage est effectué en présence de $SiO_2$, et environ 2,5% du volume total lorsque le décapage est effectué en présence de $Si_3N_4$.

8. Procédé selon l'une quelconque des revendications 1 à 7, caractérisé en ce que le rapport de vitesse de décapage est commandé, outre par la composition dudit mélange gazeux, par la pression du gaz dans la chambre de réaction et par la puissance initiale (watt/cm²).

9. Application du procédé selon l'une quelconque des revendications 1 à 8 pour fabriquer des circuits à très haute densité d'intégration.

**Claims**

1. Method for the reactive ion etching of silicon, where the silicon regions to be etched are contacted with a plasma which is generated using a gas mixture containing $SF_6$ and an inert gas, characterized in that $Cl_2$ is additionally admixed to the gas mixture.

2. Method as claimed in claim 1, characterized in that the gas mixture is composed in such a manner that the portion of $SF_6$ and $Cl_2$ is approximately 10 volume-%, and that the rest consists of an inert gas.

3. Method as claimed as any one of claims 1 or 2, characterized in that the $SF_6$ portion of the gas mixture is set at a value between 1 and 9 volume-%.

4. Method as claimed in any one of claims 1 to 3, characterized in that as an inert gas helium or argon is used.

5. Method as claimed in any one of claims 1 to 4, characterized in that polycrystalline silicon is etched.

6. Method as claimed in any one of claims 1 to 5, characterized in that the silicon is etched in the presence of $SiO_2$ or $Si_3N_4$.

7. Method as claimed in claim 6, characterized in that if etched in the presence of $SiO_2$ the $SF_6$ portion of the gas mixture is fixed at approximately 5 volume-%, and in the presence of $Si_3N_4$ at approximately 2.5 volume-%.

8. Method as claimed in any one of claims 1 to 7, characterized in that apart from being controlled via the composition of the gas mixture, the etch rate ratio is additionally controlled via the gas pressure in the reaction chamber, and via the initial power (watt/cm²).

9. Applying the method as claimed in any one of claims 1 to 8 in the production of very large scale integration circuits.

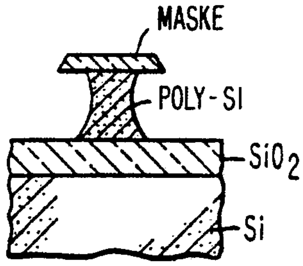


FIG. 1A

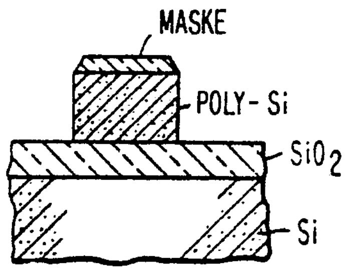


FIG. 1B

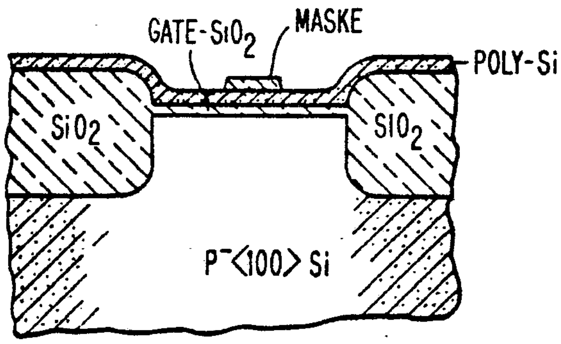


FIG. 5A

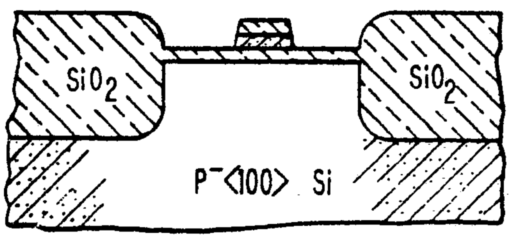


FIG. 5B

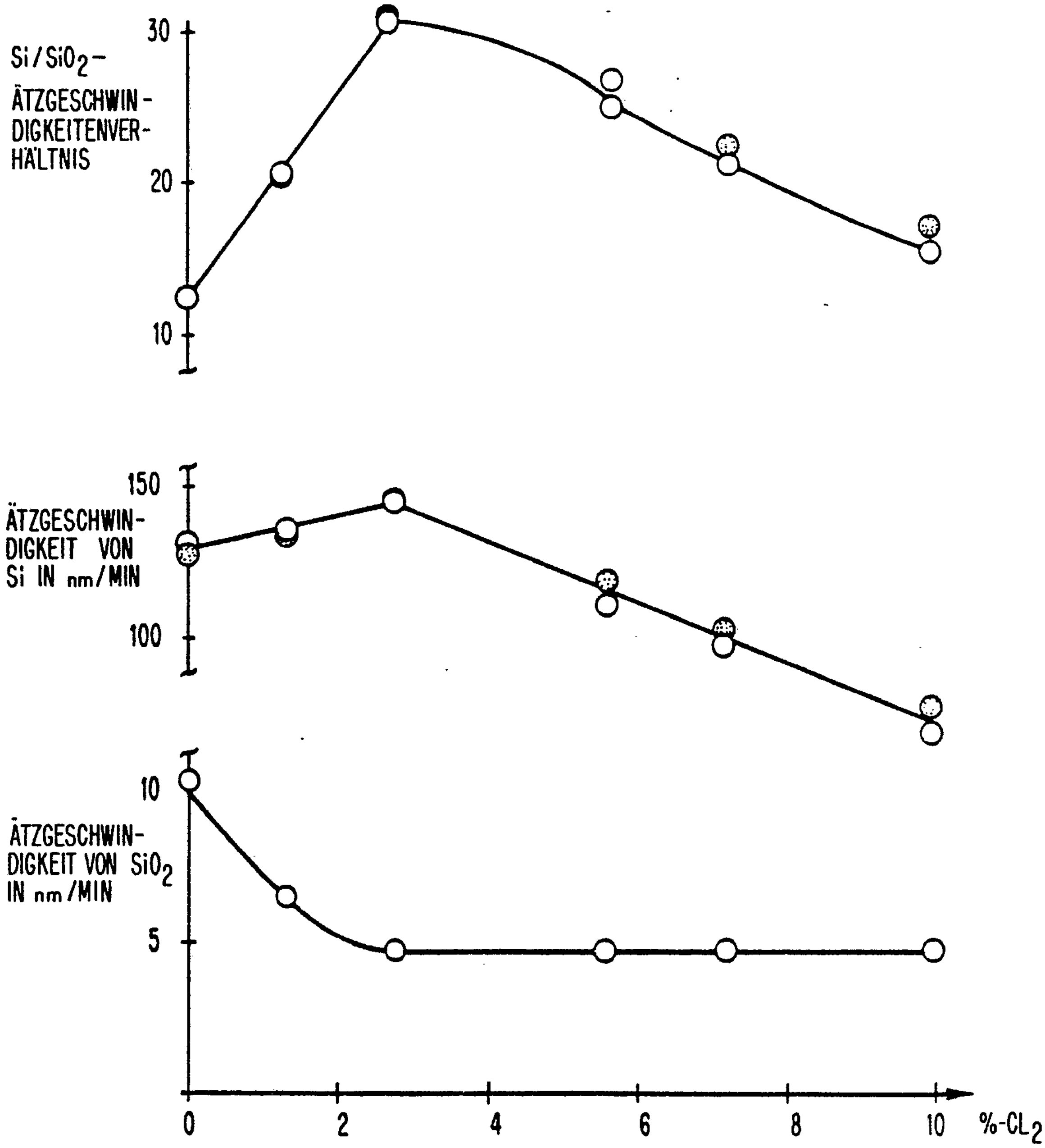
Si / SiO2 - ÄTZGESCHWIN-DIGKEITENVER-HÄLTNIS
30
20
10
150
ÄTZGESCHWIN-DIGKEIT VON Si IN nm/MIN
100
10
ÄTZGESCHWIN-DIGKEIT VON SiO2 IN nm/MIN
5
0
2
4
6
8
10
%-CL2

FIG. 2

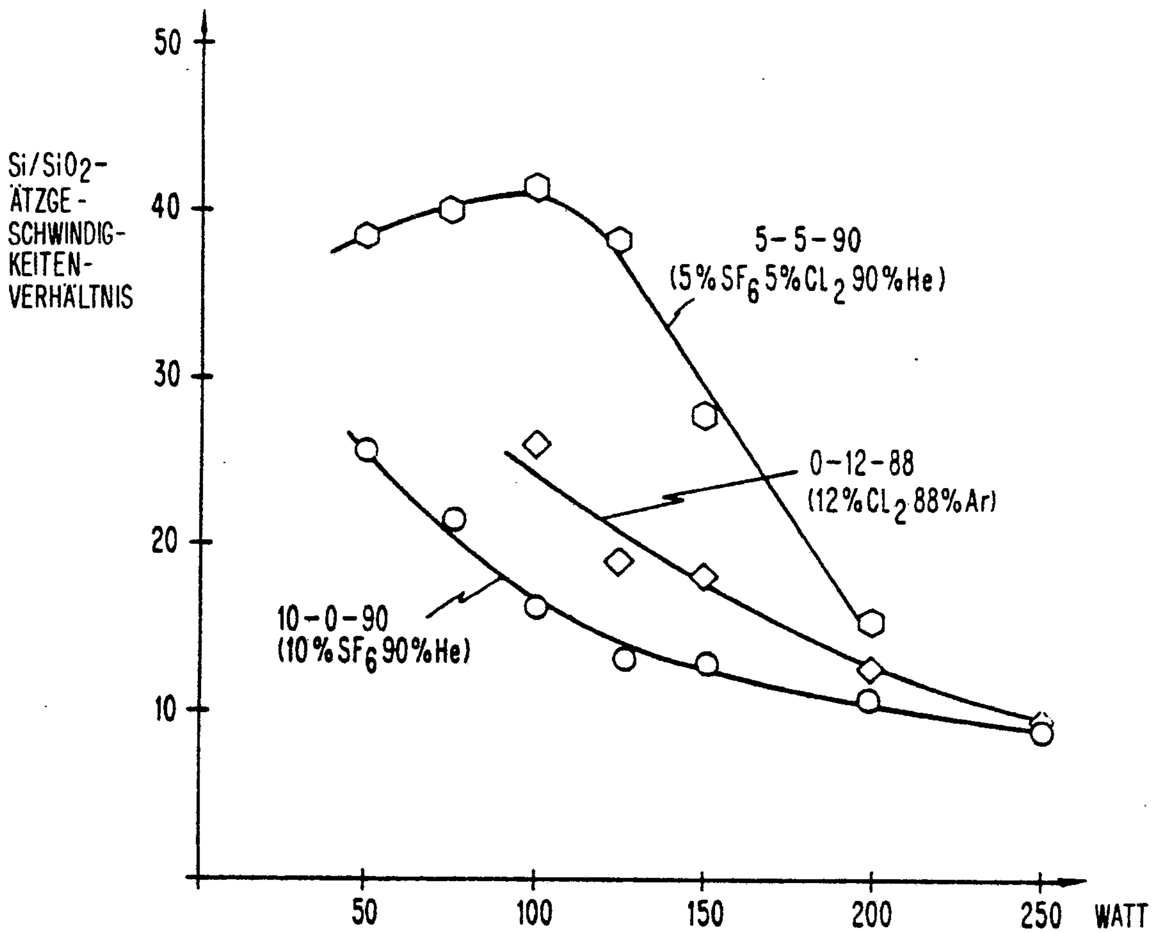

Si/SiO2-
ÄTZGE-
SCHWINDIG-
KEITEN-
VERHÄLTNIS
50
40
30
20
10
50
100
150
200
250
WATT
5-5-90
(5% SF6 5% CL2 90% He)
0-12-88
(12% CL2 88% Ar)
10-0-90
(10% SF6 90% He)


FIG. 3

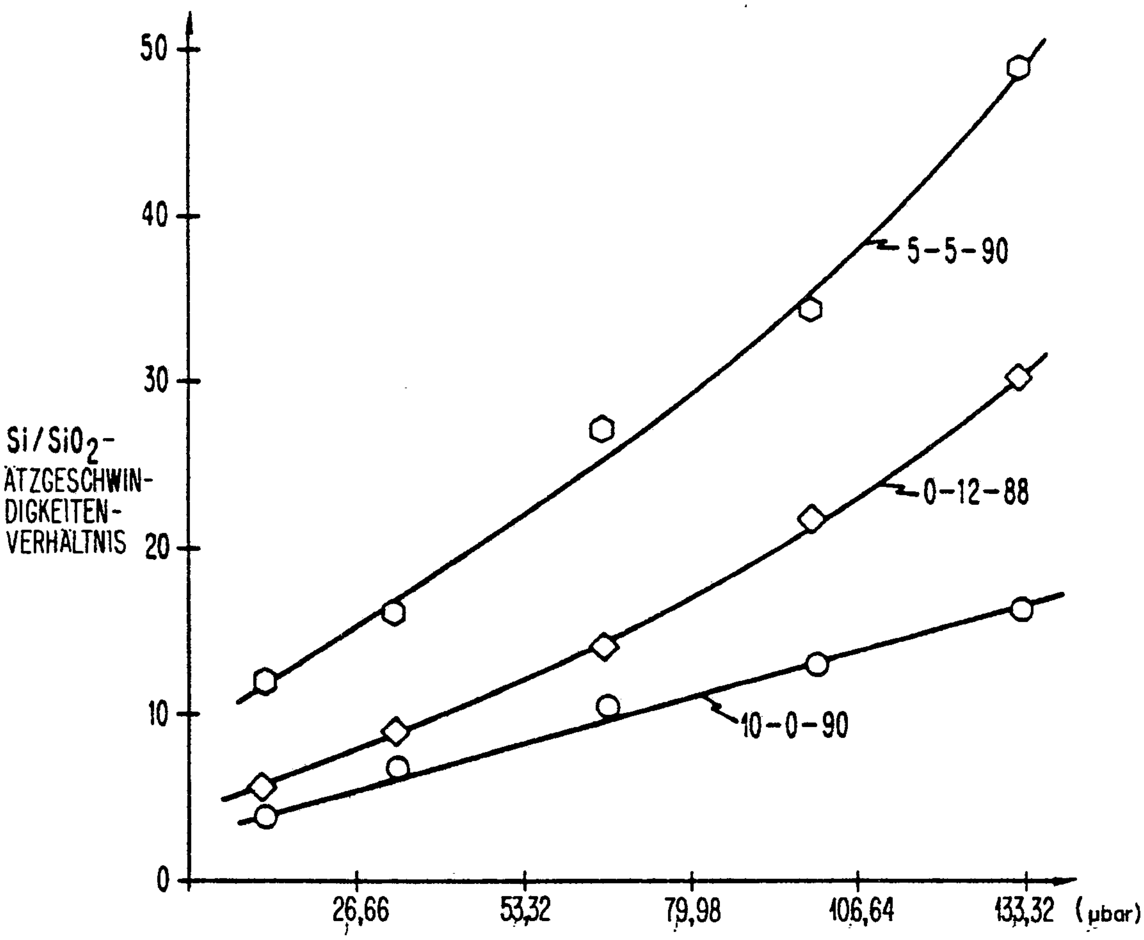

Si/SiO2-
ÄTZGESCHWIN-
DIGKEITEN-
VERHÄLTNIS
50
40
30
20
10
0
26,66
53,32
79,98
106,64
133,32
(µbar)
5-5-90
0-12-88
10-0-90


FIG. 4

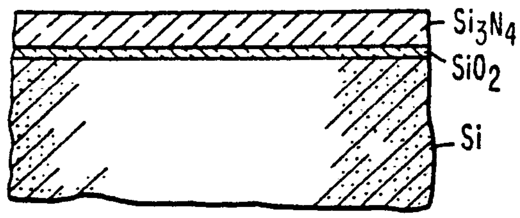


FIG. 6A

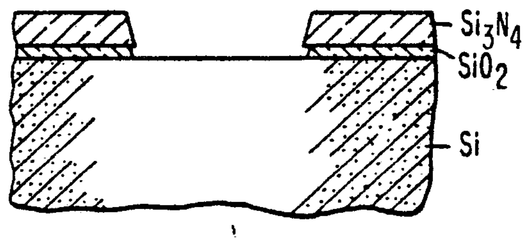


FIG. 6B

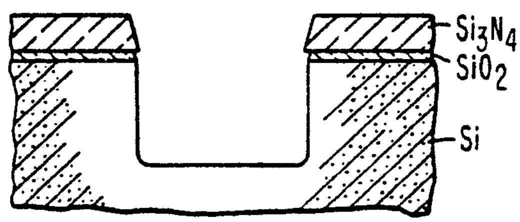


FIG. 6C

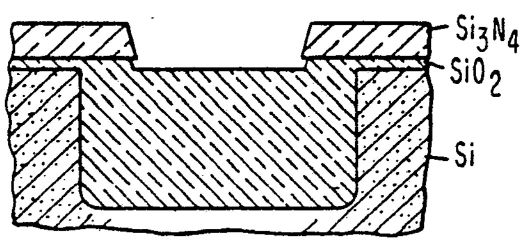


FIG. 6D